# EUROPEAN PATENT APPLICATION

(11) **EP 1 965 437 A1**
(43) Date of publication of application: **03.09.2008**
(21) Application number: 07116369.5
(22) Date of filing: 13.09.2007
(51) Int. Cl.: H01L 29/786, H01L 29/739, H01L 29/417, H01L 21/336

(54) **Nano-scale transistor device with large current handling capability**

(30) Priority: 28.02.2007 EP 07103261
(71) Applicant: K.N. Toosi University of Technology, 16314 Teheran (IR)
(72) Inventor: Raissi, Farshid, Tehran 63918-53314 (IR); Sheikhian, Iraj, Khouzestan, Izeh 63918-46977 (IR)
(74) Representative: P&TS Patents & Technology Surveys SA

(57) **Abstract**

A novel nano-scale bulk or ultra thin SOI transistor having large Ion current, small output resistance and methods to fabricate the same are disclosed. The SOI device preferably includes a substrate with buried oxide layer deposited thereon and an ultra thin active layer deposited on the buried oxide layer. The transistor has an active region defined by isolation regions, the active region having a source and a drain with a body disposed there between. An oxide insulating layer is disposed over the active region between the source and the drain. On top of this oxide layer are deposited two gates adjacent to each other with a small gap separating them. The side of one gate reaches the source and the side of the other reaches the drain. The source and the drain are each composed of two oppositely doped regions.

## Description

### Field of the invention

The present invention relates to ultra thin transistors. More particularly, the present invention relates to a metal-oxide-semiconductor field effect transistor (MOSFET) transistor with nano-size channel length shorter than 80nm and very large current carrying capabilities.

### Description of related art

Relevant US patents: 6,946,371 9/2005 Langdo et al.
7,109, 532 9/2006 Lee et al.
6,995,452 2/2006 Cho et al.
7,064,036 6/2006 Zahurak et al.
6,790,732 9/2004 Zahurak et al.
6,815,738 11/2004 Rim
6,995,452 7/2006 Cho et al.
6,753,579 6/2004 Baba
6,723,587 4/2004 Cho et al.

Further references:
1- H.-S. P. Wong, D. J. Frank, P. M. Solomon, C. H.-J. Wann, and J. J. Welser, "Nanoscale CMOS," Proc. IEEE, vol. 87, no. 4, pp. 537-570, 1999.
2- T. Mizuno, "New channel engineering for sub-100 nm MOS devices considering both carrier velocity overshoot and statistical performance fluctuations," IEEE Trans. Elec. Dev. vol. 47, no. 4, pp. 756-761, 2000.
3- C. Qiang, E. M. Harrell, J. D. Meindl, "A physical short-channel threshold voltage model for undoped symmetric double-gate MOSFETs, " IEEE Trans. Electron, Dev. vol. 50, no. 7, pp. 1631-1637, 2003.
4- S. Mahapatra, C. D. Parikh, V. R. Rao, C. R. Viswanathan, J. Vasi, "Device scaling effects on hot-carrier induced interface and oxide-trapped charge distributions in MOSFETs," IEEE Trans. Elec. Dev. vol. 47, no. 4, pp. 789-796, 2000.
5- E. Murakami, T. Yoshimura, Y. Goto, S. Kimura, "Gate length scalability of n-MOSFETs down to 30 nm: Comparison between LDD and non-LDD structures,"IEEE Trans. Electron Dev. vol. 47, no. 4, pp. 835-840, 2000.
6- D. S. Ang, C. H. Ling, "A reassessment of ac hot-carrier degradation in deepsubmicrometer LDD N-MOSFET," IEEE Electron Dev. Lett., vol. 24, no. 9, pp. 598-600, 2003.
7- F. Raissi and James E Nordman "Josephson fluxonic diode", Appl. Phys. Lett, vol.65, no. 14, p. 11838, 1994
8- F. Raissi, "A brief analysis of the field effect diode and breakdown transistor,"IEEE Trans. Electron Devices, vol. 43, no. 2, pp. 362-365, 1996.
9- I. Sheikhian and F. Raissi, " High-speed digital family using field effect diode," Elec. Lett., vol. 39, no. 4, pp. 345- 347, 2003.
10- I. Sheikhian and F. Raissi, 'An improved differential comparator with field effect diode output stage', J. Circ. Sys. Comp. vol. 14, no. 5, pp. 931-938, 2005.
11- C. Dwyer, L. Vicci, R. Taylor, 'Performance simulation of nanoscale silicon rod field-effect transistor logic' IEEE Trans. Nanotechnology, vol. 2, no 2, 2003.

Silicon-on-Insulator (SOI) technology employs a layer of semiconductor material formed over an insulating layer disposed on a supporting bulk material. Field effect transistors such as MOSFETs, which are fabricated in the upper semiconductor layer (Si) of a SOI structure, are well known in the prior art. Typically, a MOSFET has a so-called gate which is a layer of polycrystalline material, for example polysilicon, disposed over a relatively thin gate oxide, the gate oxide is placed over the Si active layer. The active layer immediately adjacent to the gate is doped with n or p type impurities which create the source and the drain side connections to the active region under the gate which is termed the channel of the transistor. SOI MOSFETs have advantages over the transistors fabricated on the conventional bulk silicon substrates.

These advantages include, among others, resistance to short-channel effect, increased current drive, higher packing density, and reduced parasitic capacitance.

SOl devices with an ultra thin active layer (less than 50 nm) have an added advantage of eliminating the so-called floating body effect which degrades the electrical performance of SOI devices with thicker active regions. However, despite their superior characteristics there are still problems associated with scaling down the size of ultra thin SOI MOSFETS (or any other MOSFET). One such problem arises from the fact that scaling the size of the transistor must be accompanied by a decrease in driving voltage; and in order to keep the same level of current drive capability, the thickness of the gate oxide layer must be decreased. However, decreasing the thickness of the gate oxide below a typical value of 2 nm causes the unwanted tunnelling of carriers from the gate into the active region, and can completely undermine the operation of the transistor due to leakage current. This is one of the most severe problems hampering further scaling of the MOSFET transistors below 80 nm channel lengths.

There is hence a lack of transistors fabricated with the same steps as the regular MOSFETs, but which could provide larger currents for the same thickness of the gate oxide, and would have an operational principle inherently devoid of some of the short channel effect problems.

The so-called Field Effect Diode (FED) proposed by the same inventor in the following applications "Josephson fluxonic diode", Appl. Phys. Lett., vol. 65, no. 14, p. 11838, 1994; and Raissi "A Brief Analysis of the Field Effect Diode and Breakdown Transistor "IEEE Transaction On Electron Device, vol. 43, no.2, p. 362, 1996 is not appropriate for nano-scale dimensions and in particular it does not act as a switch when the active channel region is shorter than 100 nm.

The term Field Effect Diode is also used for another device used as a current limiter. This device is a Junction Field Effect Transistor (JFET) whose gate is tied to its source. It acts similar to a diode, hence the name field effect diode. These devices are being manufactured as current limiters by Siliconix, which makes two-lead FET current-limiting diodes ranging from 0.24 mA (J500) through 4.7 mA (J511) in plastic packages, and from 1.6 mA (CR160) through 4.7 mA (CR470) in metal TO-18 packages, and by National Semiconductor, which makes a three-terminal adjustable device, the LM134/LM234/LM334, that acts as a resistor-programmed current source diode, analogous to the 'programmable Zener' TL431. Also, Motorola used to make current limiting diodes, MCL1300 series, with 75V operating range and 0.5 mA to 4 mA current.

Double gate, dual gate and multi gate MOSFETs are also well known in the art, such as the patents US 7,064,036, US 6,790,732 and US 6,815,728; however the design, basis of operation and electrical characteristics of such structures are completely different from the object of the invention.

### Brief summary of the invention

The invention disclosed aims to provide the aforementioned advantages over the regular ultra thin SOI MOSFETs.

According to the invention, these aims are achieved by means of an ultra thin) transistor, comprising an active region disposed between the source and drain regions, two gates disposed side by side over the active channel region between the source and the drain and operable under bias to affect carrier density inside the active region, and an extra dopant region against the source and the drain regions. The extra dopant region is of the opposite doping type compared to the one of the source and the drain regions.

The invention provides high current handling capability, making it possible to achieve channel lengths well below 80 nm without the need to decrease the gate oxide thickness which caused detrimental problems. It provides a current that is orders of magnitude larger than a comparable MOSFET of the same dimension and it does not suffer from some of the short channel effects that hamper the operation of MOSFETs at channel lengths shorter than 100 nm. The fabrication process of this device is similar to the standard CMOS process. In particular, in one of the embodiments of this invention it is identical to CMOS process while in two other embodiments simple changes must be made to the regular CMOS process for its manufacture. On the other hand, due to its operational principle there is no need for Lightly Doped Drain (LDD) or halo implants.

The present invention also discloses possible methods for manufacture such devices. The novel transistor is a modified version of the so called Field Effect Diode (FED) which comprises two gate electrodes disposed side by side over the channel region between the source and the drain. The source and the drain of the present invention comprise two oppositely doped regions. The extra region in the source and the drain are needed to make a contact between the source and the channel and between the drain and the channel when the device is turned off. If these regions are not provided, FED does not turn off for channel lengths shorter than 100 nm.

More specifically, the present invention also provides methods to fabricate the said regions inside the source and the drain. They can be fabricated either by epitaxial growth, use of metal or alloys in place of the semiconductor source and drain, or by placing the two oppositely doped regions side by side along the width of the device. The above and other advantages and features of the present invention will be more clearly understood from the following detailed description which is provided in connection with the accompanying drawings.

### Brief Description of the Drawings

The invention will be better understood with the aid of the description of an embodiment given by way of example and illustrated by the figures, in which:
Fig. 1 shows a cross-sectional view of the modified FED in one of the simplest embodiments of the present invention.
Fig. 2 shows a cross-sectional view of the FED in accordance with the prior art.
Fig. 3 shows a cross-sectional view of the modified FED in one of its possible embodiments using epitaxial growth of the source and the drain.

### Detailed Description of possible embodiments of the Invention

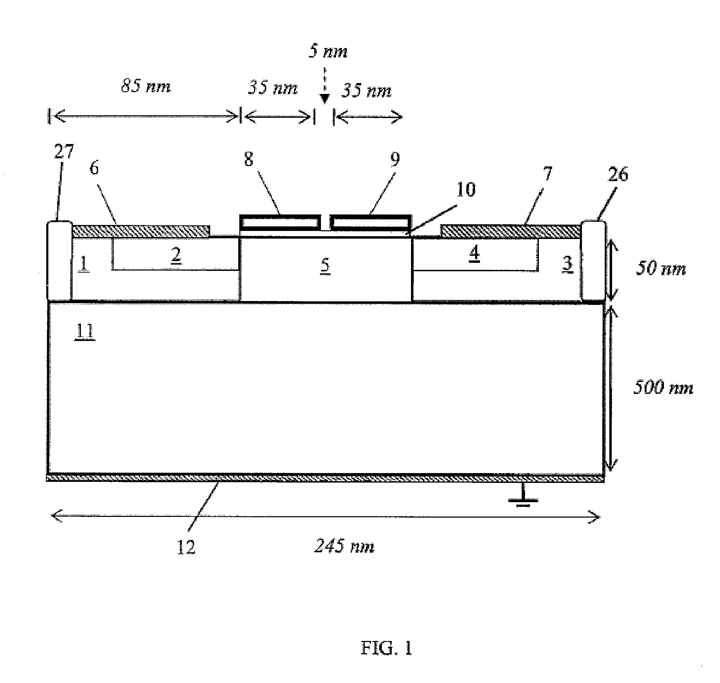

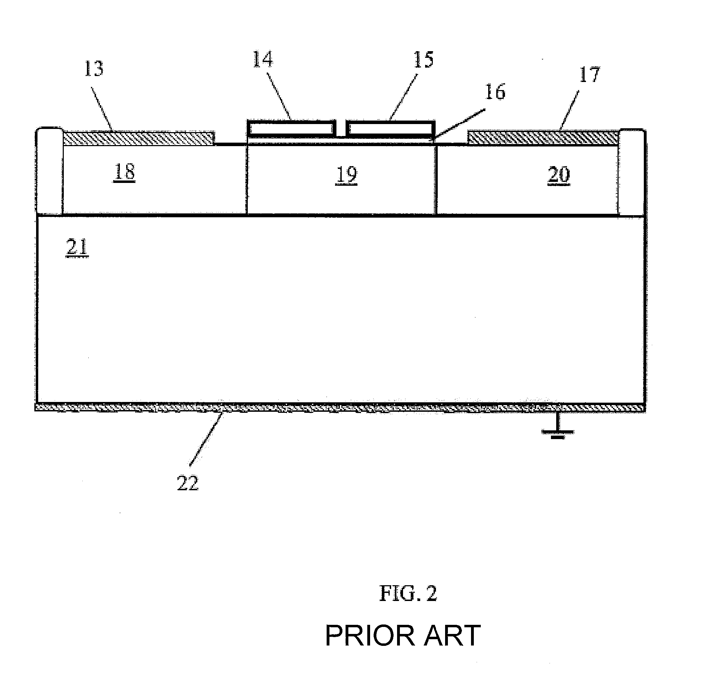

The illustrations of the present invention are given for the sake of clarity but should not be considered as limitative. Other embodiments of the invention will readily suggest themselves to such skilled persons. Referring first to FIG. 1, a cross-sectional view is shown of an illustrative embodiment of the present invention for dimensions most relevant in today's electronic circuitry, but persons of ordinary skill in the art will readily appreciate that the specific geometry and dimensions employed for the device of present invention could be any of the structural arrangements or dimensions appropriate for an application. In addition, the present invention is disclosed using terms "source", "drain", "1ₛₜ gate" and "2_{nd} Gate" to be relative and not absolute and the processing involved in making appropriate gate structures, source and drain contacts, spacers and other manufacturing steps which are already in use in semiconductor industry are not illustrated to make the particular points of novelty of present invention clear. There are at least two physical features which are different from regular MOSFETs, one being the placement of two gates over the active region and the other is the particular doping of the source and the drain. The 1stgate 8 and 2nd gate 9 in FIG. 1 are placed over the gate oxide 10. These two gates control the carrier densities (electrons and holes) inside the intrinsic (or lightly doped) channel 5. The ultra thin semiconductor layer including portions 1, 2, 3, 4 and 5 are placed over the insulator material 11. The insulating material is covered by a conducting material at the bottom, which is termed back gate and is designated by number 12. Sections 1 and 2 are highly doped with p+ and n+ impurities of any type, respectively. Sections 3 and 4 are highly doped with p+ and n+ impurities of any type, respectively. We call the section comprising 1 and 2 as the "source", and we call the section comprising 3 and 4 as the "drain". We also call the sections 2 and 4 as "reservoirs". Metal contacts 6 and 7 make ohmic contact to the source and the drain. Regions 26 and 27 are the isolation regions which separate the transistor form its adjacent neighbouring devices. As will be appreciated by persons of ordinary skill in the art, other layers may be formed over the gates and the metal contacts may be of varying materials in order to complete the fabrication of the integrated circuit device containing the device of present invention. The FED proposed in the prior art is not appropriate for channel lengths shorter than 100 nm, while the new modified version can operate at shorter lengths and it has been simulated with exceptional results for a channel length of 75 nm. The difference between our present invention, which we will call modified FED from now on, and the regular FED of the prior art is in the doping profile of the source and the drain. FIG. 2 demonstrates a regular FED, as proposed by Raissi in prior art, and it can be observed that the source and the drain designated by 18 and 20 are only doped with one type of impurity. In the modified FED of the present invention reservoirs 2 and 4 have been added.

These reservoirs make operation of the present invention possible at 75 nm channel lengths or even less. To understand the role that these reservoirs play, we first examine the operational principle of regular FED as provided in FIG. 2. If the source 18 is grounded and the 1st gate 14 is positively biased with respect to the source and the 2nd gate 15 is negatively biased with respect to the source, then electrons accumulate under the 1^{st} gate inside the active region and holes accumulate under the 2nd gate inside the active region. If further the drain 17 is positively biased with respect to the source, a current flows from the source to the drain. The combination of the source/active region/ drain resembles a pn junction diode in its ON state and in fact the current-voltage characteristic is exactly that of a forward bias diode. If the bias voltage applied to the drain is increased the voltage difference between the drain and the 2_{nd} gate 15 increases as well. This means that a so called pinch-off region is never created inside the active region of the device. The occurrence of pinch-off is the limiting factor for the maximum current of a regular MOSFET. Therefore, there is no limit to the maximum current which FED can provide except for the parasitic resistances of the rest of the device or circuitry. In fact, it has been shown in prior art that the current of FED can be about three orders of magnitude larger than a MOSFET for the voltage ranges of the interest. Now, if the voltage polarities of the gates are reversed, meaning that the 1st gate 14 is negatively biased with respect to the source and the 2_{nd} gate 15 is positively biased with respect to the source, then holes accumulate under 1 st gate inside the active layer and electrons accumulate under the 2nd gate inside the active layer. The combination of the source/channel/drain resembles an n+pnp+ structure and if the drain is biased with a positive voltage with respect to the source, the device is a thyristor in its OFF state. The OFF state current is comparable or less than the OFF current of a regular MOS with the same dimensions. This device, therefore, can act as an electronic switch with a very large driving current which makes it attractive for digital electronics as well as some analogue circuits. Such analogue and digital applications have been proposed and demonstrated in prior art: Iraj Sheikhian et al, ' High-speed digital family using field effect diode', IEEElectronics Letters, vol 39, no 4, p 345, 2003; 1. Sheikhian et al, 'An improved differential comparator with field effect diode output stage', J. Circ. Sys. Comp. vol. 14, no. 5, pp. 931-938, 2005. The performance of FED; however, is greatly compromised when the channel region under the gates is shorter than 100 nm or alternatively when the length of each gate is less than 50 nm. In particular, when the length of the channel is less than 90 nm the device does not turn off. Using the PISCES-IIb drift-diffusion solver we obtained carrier density, electric field, potential and current-voltage curve of the nano sized FED. It was observed that, when the gate voltage polarities are such that the active region must resemble a thyristor in its OFF state, with an n+pnp+ structure, the active region shows an n+ip+ structure, where "i" stands for intrinsic.

The reason for such behaviour is easily understood if we consider the n+pnp+ structure which is supposed to create the OFF state. Since a positive voltage is applied to the drain with respect to the source the n+p junction in the source side is forward biased, the pn junctions in the active region is reverse biased, and the np+ junction between the active region and the drain is again forward biased. Ordinarily, the reverse biased junction at the centre determines the current as the limiting factor.

However, when the gate lengths shrink below 50 nm, the p and n regions under each gate are also accordingly shrunk and the minority injected electrons coming from the source side can diffuse without recombination and enough of them can reach the active region under the 2_{nd} gate, also the minority holes injected from the drain can reach the active region under 1 st gate, such that the thyristor turns on. Therefore, there is a minimum size associated with the gates of FED for proper operation which is a function of the diffusion constant and their recombination time.

One way to overcome this problem in order to decrease the size of FED below 100 nm is to decrease the diffusion constant and recombination time of the carriers, but there is another method which seems more appropriate.

To alleviate this problem we need to eliminate or decrease the number of injected minority carriers which can make it across the length of the gates. These carriers are injected because the n+p and np+ junctions in the source and the drain side are forward biased. It is then proper to create a situation in which these junctions are not forward biased. If one could short circuit the n+p and np+ junctions such detrimental injection of minority carriers would not take effect.

The doping profile of the source and the drain as depicted in Fig. 1 does provide such a situation. First notice that regions 1 and 2 and also regions 3 and 4 are connected to each other by contacts 6 and 7. Second, notice that regions 1 and 3 are also in contact with the active layer underneath each gate. Since the p region under the 1^{st} gate and the n region under the 2_{nd} gate cover the whole thickness of the active layer, the ultra thin Si makes that possible, n+p and np+ junctions are in fact short circuited and as a result the injection of minority carriers is eliminated, or greatly reduced if the short circuit is not ideal.

The current-voltage relation between the source and the drain of the transistor device according to the invention can also be controlled by independently biasing the two gates as the FED of the prior art. We have simulated this structure using PISCES-IIb simulator and have obtained current drives which are one to two orders of magnitude larger than comparable SOI devices. There does not seem to be any restriction on the minimum size that this modified FED can be reduced to until such dimensions that the quantum mechanical effects become dominant in which case the behaviour of FED is not currently known.

While the general processing steps for fabrication of the disclosed modified FED as provided in FIG.1 is the same as standard CMOS fabrication techniques, some extra steps must be introduced to create regions 1 and 2 and also 3 and 4. One particular problem arises due to the fact that regions 1 and 3 must be very highly doped to provide a good contact to the active region under the gates. This requires that regions 2 and 4 to be highly doped as well. Ion implanting region 2 over region 1 and region 4 over region 3 may not be practically feasible with today's technology as the depth of regions 2 and 4 are very shallow.

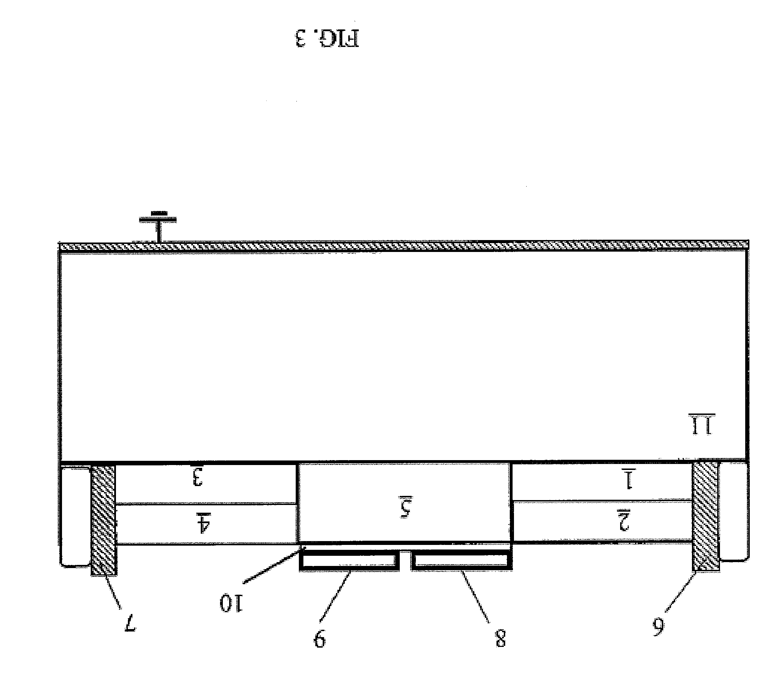

In one embodiment of this invention the n+ and p+ regions in the source and also the n+ and p+ in the drain side can be placed side by side along the width of the device and they can cover the whole depth of the active layer and also the distance between the gates and the isolation regions. Such an embodiment requires an identical manufacturing process as that of CMOS fabrication. In another embodiment of the invention we can make use of epitaxial growth of the source and the drain as proposed in prior art. In particular US 6,946,371, Sept 20, 2005 Langdo, et al. "Methods of fabricating semiconductor structures having epitaxially grown source and drain elements" can be used or other relevant methods disclosed in the art. For such an embodiment, a configuration given in FIG. 3 can be used. In this embodiment regions 1 and 3 are first grown to appropriate thickness and doping levels, then regions 2 and 4 are grown on top with appropriate doping levels. In this case, the upper portions corresponding to regions 2 and 4 extend from the edges to the gates such that they cover the lower portions corresponding to the regions 1 and 3 completely.

The source contact 6 and the drain contact 7 are then made through trenches created through regions 1 and 2 and regions 3 and 4.

In another possible embodiment (not illustrated), the source and the drain regions of the transistor device of the invention can comprise two alternative portions of opposite doping type, said portions being created side by side along the width of the source and the drain and wherein contact is made to all of them.

The transistor device according to the invention was originally proposed to be fabricated on SOl material, in order not to undermine the operation of the modified FED because of the induced current path from the source to the drain. Nevertheless, simulations have shown that the modified version of the FED can also work at nanoscale dimensions with a bulk material. The advantage to use a bulk material is that it is cheaper and easier to fabricate compared to the SOI process.

## Claims

1. An ultra thin silicon-on-insulator (SOI) or bulk transistor device, comprising:
- An active region disposed between source and drain regions in, two gates disposed side by side over the active region between the source and the drain and operable under bias to effect carrier density inside the active region; and
- an extra dopant region against the source and the drain regions, the extra dopant region being of a doping type opposite that of the one of the source and the drain regions.

2. The transistor device according to claim 1, said device being a silicon-on-insulator (SOI) or transistor device, comprising:
- a thin active region disposed between source and drain regions in a layer of silicon over an insulator, two gates disposed side by side on an insulator over the active region and operable under bias to effect carrier density inside the active region; and
- an extra dopant region against the source and the drain regions, the extra dopant region being of a doping type opposite that of the one of the source and the drain regions.

3. The device of claim one of the preceding claims, said device acting as a transistor whose current-voltage relation between the source and the drain are controlled by independently biasing the two gates.

4. The device of one of the preceding claims, in which the source and the drain regions comprise:
a lower portion proximate the insulator of a first doping type;
and an upper portion proximate a surface of the layer of silicon of a second doping type,
wherein the upper portion extends from the edge of the gate such that it covers the lower portion only partially;
wherein a contact is made to both portions;
and wherein the upper and lower portions are created through Ion implantation.

5. The device of one of the claims 1 to 3, in which the source and the drain regions comprise:
a lower portion proximate the insulator of a first doping type;
and an upper portion proximate a surface of the layer of silicon of a second doping type;
wherein the upper portion extends from the edge of the gate such that it covers the lower portion completely;
and wherein the upper and lower portions are created through epitaxial growth and are etched to make contact to both portions.

6. The device of one of the preceding claims, in which the source and the drain regions comprise two alternative portions of opposite doping type, said portions being created side by side along the width of the source and the drain and wherein contact is made to all of them.

7. The device of one of the preceding claims, in which the channel length is lower than 80nm.

8. The device of one of the preceding claims, in which the gate region and the source region are in electrical contact with the respective extra dopant region.

9. The device of the previous claim, comprising metallic source and drain contacts connected to the source and to the extra dopant source region, respectively to the drain and to the extra dopant drain region.
